# EUROPEAN PATENT SPECIFICATION

(11) **EP 4 779 434 B1**
(45) Date of publication and mention of the grant of the patent: **09.12.2026**
(21) Application number: 25152786.7
(22) Date of filing: 20.01.2025
(51) Int. Cl.: G06F 1/18, H05K 7/14

(54) **COMPUTER SYSTEM COMPRISING HORIZONTAL BLADES AND VERTICAL BLADES**
RECHNERSYSTEM MIT HORIZONTALEN BLÄTTERN UND VERTIKALEN BLÄTTERN
SYSTÈME INFORMATIQUE COMPRENANT DES LAMES HORIZONTALES ET DES LAMES VERTICALES

(43) Date of publication of application: 22.07.2026
(73) Proprietor: ExpectedIT GmbH, 73728 Esslingen am Neckar (DE)
(72) Inventor: Steinmacher-Burow, Burkhard, 73728 Esslingen am Neckar (DE); Ingimundarson, Arni, 76137 Karlsruhe (DE); Hüls, Harald, 73728 Esslingen am Neckar (DE)
(74) Representative: Witte, Weller & Partner Patentanwälte mbB

(56) References cited:
- WO-A1-2012/161712
- US-A1- 2005 207 134
- US-A1- 2019 098 788

## Description

### Background of the invention

The present invention relates to a computer system, wherein the computer system comprises a plurality of horizontal blades and a plurality of vertical blades.

Computer systems are generally known in the art. For example, computer systems with multiple computing units can be used in data centers. In general, a data center is a building, a dedicated space within a building, or a group of buildings used to house computer systems and associated components, such as telecommunications and storage systems. In particular, the computer systems as well as the associated components can be arranged in racks within the data center.

In general, computer systems may comprise a plurality of electric and/or electronic components. In particular, computer systems may comprise a plurality of blades in which the electric and/or electronic components can be arranged, in particular mounted. These blades can be arranged in a rack or chassis. A blade may also be called a sled. For example, a blade may comprise a frame or a housing, wherein one or more electric and/or electronic components, such as boards, cables, chips, connectors, and the like, are arranged or mounted with respect to the housing or frame of the blade.

In general, a computer system based on blades is as follows. Each blade can be relatively easily removed, replaced or inserted into the chassis or rack, without disturbing the other blades. Once inserted, a blade is latched or otherwise affixed to the chassis or rack, so that the blade does not move when other blades are inserted or removed. An inserted blade has one exposed side, while its other 5 sides are within the chassis. A blade's exposed side may have one or more connectors for one or more cables external to the blade. Such an external cable may connect the blade to a network switch or other system beyond the blade's computer system. Opposite to a blade's exposed side is its back side. To connect the components within the blade to other components in the computer system, a blade does not use cables external to the blade. Instead, a blade has connectors mounted at its back side to connect components within the blade to other components in the computer system. For a blade's back-side connectors, the counterpart connectors can be on a midplane or backplane or on other blades or other subsystems. When a blade is inserted into the chassis or rack, the blade's back-side connectors blind-mate with its counterpart connectors. When a blade is removed from the chassis or rack, the blade's back-side connectors disengage from their counterpart connectors.

Some known computer systems use different types of blades, in particular blades of a first type and blades of a second type. The blades of the first type may include computing units of computer system. For example, the blades of the first type may be called computing blades or device blades. The blades of the second type may comprise electronic components (such as switch chips or fabric chips) that manage communication between the blades of the first type, in particular for exchange of data, shared access to memory, and the like. For example, the blades of the second type may be called switch blades or fabric blades.

The blades of the first type may be connected with the blades of the second type via an orthogonal connection. In the orthogonal connection, each blade of the first type is connected to each blade of the second type, and vice versa. Computer systems in which blades are connected via an orthogonal connection may also be called orthogonal systems or orthogonal computer systems.

In orthogonal computer systems, the orthogonal connection between the two types of blades can be direct. Such an orthogonal connection may also be called orthogonal-direct connection. In this case, each blade of the first type is directly connected to each blade of the second type. For this, the blades of the two types may be arranged orthogonally to each other, e.g. blades of one type horizontally and blades of the other type vertically. For instance, a computer system with an orthogonal-direct connection of blades is shown in document EP 4 322 718 A1.

Further, in orthogonal computer systems, the orthogonal connection between the two types of blades can also be indirect. For example, the blades of the different types may be connected to each other via a midplane or a backplane.

For instance, document US 7 929 310 B2 shows a cell board interconnection architecture that comprises an interconnection structure for interconnecting a plurality of cell boards, wherein the interconnection structure is configured to allow air to pass therethrough in a direction in which the cell boards couple therewith.

Further, document US 8 861 222 B2 shows a backplane that includes multiple vertical insertion plates separately arranged from each other. Connectors connecting circuit boards and a circuit serving as signal wiring are disposed on the vertical insertion plates. Each connector is electronically connected to the circuit of the vertical insertion plate on which the connector is disposed, so that when the connector on the vertical insertion plate connects a switch board with a service board, the switch board and the service board can implement signal interconnection through the signal wiring of the vertical insertion plate.

Further, document US 9 059 551 B2 shows a backplane apparatus, including a first backplane structure and a second backplane structure, where the first backplane structure is configured to transmit power and low-speed signals, and the second backplane structure is configured to transmit high-speed signals, low-speed signals, or optical signals. The first backplane structure includes a first backplane, multiple first connectors, and a connected space, where the first connectors are arranged on the first backplane and boards are electrically connected to the first backplane. The second backplane structure includes multiple second backplanes and multiple second connectors, where the second connectors are arranged on the second backplanes, the second backplanes are installed on the first backplane, and the second connectors are electrically connected to boards by crossing the connected space or via the first connectors. Further, there is disclosed a communication device.

Further, document US 2005/207134 A1 shows a cell board interconnection architecture comprises an interconnection structure for interconnecting a plurality of cell boards, the interconnection structure configured to allow air to pass therethrough in a direction in which the cell boards couple therewith.

Further, document US 2019/098788 A1 shows that an example frame shuffle is communicatively coupled to a midplane of a frame. The frame shuffle includes a first group of optical connectors. Each of which are communicatively coupled to a resource device via the midplane. The frame shuffle also includes a second group of optical connectors, each of which communicatively couples with a frame shuffle of an adjacent frame. The frame shuffle also includes a routing device to optically interconnect the resource devices and another group of resource devices of the adjacent frame. The frame shuffle also includes a frame shuffle fan to provide fresh air through the frame shuffle and direct exhaust air through the midplane.

Further, document WO 2012/161712 A1 shows a blade computer system that comprises side-by-side computer blades, a connectivity module extending across and connected to each of the plurality of side-by-side computer blades along the ends of the computer blades and at least one first power supply-fan unit extending perpendicular to the first axis and directly connected to each of the first plurality of side-by-side computer blades along ends of the plurality of side-by-side computer blades such that the at least one power supply-fan unit draws air across the first plurality of side-by-side computer blades and into the first connectivity module.

The known computer systems still leave room for improvements, in particular with respect to cooling efficiency, compactness, replacement of blades, and mechanical stability.

### Summary of the invention

Against this background, it is an object of the present invention to provide an improved computer system. In particular, it is an object to improve a computer system with respect to at least one of cooling efficiency, compactness, replacement of blades, and mechanical stability. The invention is set out in the appended set of claims.

According to an aspect of the invention, there is provided a computer system, wherein the computer system comprises:
- a plurality of vertical blades;
- a plurality of horizontal blades, the horizontal blades comprising top horizontal blades and bottom horizontal blades, the top horizontal blades being arranged above the vertical blades, the bottom horizontal blades being arranged below the vertical blades; and
- a plurality of connecting blades, the connecting blades comprising top connecting blades and bottom connecting blades,
wherein each top connecting blade is connected to one of the vertical blades and to each top horizontal blade, wherein each bottom connecting blade is connected to one of the vertical blades and to each bottom horizontal blade, wherein each horizontal blade and each vertical blade comprises at least one electronic component, wherein the electronic components of the horizontal blades and the electronic components of the vertical blades are connected in a leaf-spine topology via the connecting blades, wherein each horizontal blade comprises at least one leaf component and each vertical blade comprises at least one spine component, wherein each leaf component is connected to each spine component via the connecting blades, wherein each horizontal blade comprises one or more computing chips and each vertical blade may comprise one or more switch chips, wherein each computing chip is a leaf component and each switch chip is a spine component.

Each vertical blade and each horizontal blade comprises one or more electronic components. With other words, the computer system may comprise multiple electronic components that are distributed over the horizontal blades and the vertical blades. For example, each horizontal blade may comprise a computing unit, in particular a computing chip. The horizontal blades may be computing blades or device blades. Each vertical blade may comprise a switch unit, in particular a switch chip or fabric chip. The vertical blades may be switch blades or fabric blades.

The vertical blades, the horizontal blades and the connecting blades of the computer system are collectively referred to as "blades". The blades of the computer system are arranged with respect to a reference system. In particular, the reference system may be a reference system of a rack in which the blades are arranged, in particular inserted. The reference system may comprise a length direction, a width direction and a height direction. The length direction and the width direction are horizontally arranged. The height direction is vertically arranged. The length direction may also be called front-rear direction. The width direction may also be called left-right direction. The height direction may also be called top-bottom direction. In particular, the terms "front", "rear", "top", "bottom", "length", "width" and "height" shall be understood with respect to this reference system. In the reference system, each blade has a length in the length direction, a width in the width direction and a height in the height direction. Further, each blade has a front side and a rear side.

The vertical blades are vertically arranged. In particular, a width of each vertical blade may be smaller than a height of each vertical blade. The horizontal blades are horizontally arranged. In particular, a width of each horizontal blade may be a greater than a height of each horizontal blade. The connecting blades may also be vertically arranged. In particular, a width of each connecting blade may be smaller than a height of each vertical blade. The vertical blades may be stacked or distributed in the width direction. The top horizontal blades may be stacked or distributed in the height direction. The bottom horizontal blades may be stacked or distributed in the height direction. The top connecting blades may be stacked or distributed in the width direction. The bottom connecting blades may be stacked or distributed in the width direction.

In the height direction, the vertical blades are arranged between the top horizontal blades and the bottom horizontal blades. In particular, the top horizontal blades are arranged above the vertical blades and the bottom horizontal blades are arranged below the vertical blades. Further, in the height direction, the top connecting blades are arranged above the bottom connecting blades. In the length direction, the vertical blades and the horizontal blades are arranged opposite to the connecting blades, in particular in front of the connecting blades. In particular, the vertical blades and the horizontal blades may be arranged at a front side and the connecting blades on a rear side of the computer system.

A connection plane may be arranged between the horizontal and vertical blades at the front side and the connecting blades at the rear side. The connection plane may be perpendicular to the length direction. The rear sides of each horizontal blade and each vertical blade may be aligned to each other, in particular with respect to the connection plane. The front sides of the connecting blades may be aligned to each other, in particular with respect to the connection plane. The connection plane may be a center plane between the horizontal and vertical blades at the front side and the connecting blades at the rear side. In particular, the rear sides of each vertical and horizontal blade and the front sides of each connecting blade may be arranged at the connection plane.

Each top connecting blade connects each top horizontal blade to one of the respective vertical blades. Each top connecting blade corresponds to a respective vertical blade. With other words, each vertical blade is connected to a top connecting blade which is further connected to each of the top horizontal blades above the respective vertical blade. Each bottom connecting blade connects each bottom horizontal blade to one of the respective vertical blades. Each bottom connecting blade corresponds to a respective vertical blade. With other words, each vertical blade is connected to a bottom connecting blade which is further connected to each of the bottom horizontal blades below the respective vertical blade.

By the connecting blades, an orthogonal connection is established between the horizontal blades and the vertical blades. The horizontal blades and the vertical blades are not arranged on opposite sides in the length direction but rather at the same side stacked over each other in the height direction. The resulting orthogonal connection via the connecting blades may be called a folded orthogonal connection. Thus, the new computer system may also be called a folded orthogonal system.

Typically, the electronic components in a computer system are cooled via a cooling airflow that passes through the computer system, in particular from the front side to the rear side. Thus, when electronic components are located at both sides of a computer system, the cooling airflows first cools the electronic components on an upstream side (for example the front side) and then cools the electronic components on the other, downstream side (for example the rear side). By cooling the electronic components on the upstream side, the air in the airflow is already preheated so that the electronic components at the downstream side are less efficiently cooled. In the new computer system, the electronic components are distributed over the horizontal blades and the vertical blades that are arranged on the same side of the computer system, in particular the front side. By providing the electronic components on the same side, it is better avoided that electronic components may be cooled with preheated air. By this, the cooling efficiency is improved.

Further, a length of the blades comprising the electronic components, namely the horizontal blades and the vertical blades, is typically relatively large in the length direction. When blades with electronic components are located on opposite sides of a computer system, namely at the front side and the rear side, the length of the computer system in the length direction is the sum of the horizontal blade length and the vertical blade length. This sum may be larger than that allowed by the typical rack length. In the new computer system, the horizontal blades and the vertical blades are provided on the same side so that the length of the computer system in the length direction can be reduced and thus fit within a typical rack length. By this, the compactness of the computer system is improved.

Further, the blades comprising the electronic components, namely the horizontal blades and the vertical blades, are typically maintained and replaced more often than connecting blades. When blades comprising electronic components are located on opposite sides of a computer system, namely at the front side and the rear side, access to these blades is needed from both sides for their replacement. In the new computer system, the horizontal blades and the vertical blades are provided on the same side so that access is only needed from one side of the computer system for their replacement. By this, the replacement of the blades comprising the electronic components is improved.

In general, torque is a force that increases with the distance due to leverage. Thus, the greater the dimension of a connecting blade is, the more torque affects the orthogonal connection. In the new computer system, the connecting blades are now divided into the top connecting blades and the bottom connecting blades. Thereby, the height of the connecting blades is reduced. In particular, each connecting blade does not connect to all horizontal blades but rather only to the top horizontal blades or the bottom horizontal blades. By this, mechanical stress affecting the orthogonal connection, especially the connectors of the blades, is further reduced. Thereby, the mechanical stability of the computer system, especially of the orthogonal connection, is improved.

Further, a longer connecting blade has a greater height and weight than a shorter connecting blade. This makes a longer connecting blade more difficult to insert or remove from a chassis and also otherwise physically handle than a shorter connecting blade. In particular, when a connecting blade extends over substantially the full height of the computer system for connecting the horizontal blades and vertical blades, the connecting blades are relatively long and difficult to handle. In particular, when a connecting blade may be inserted or removed, for example during the replacement of a connecting blade, this may require an overly large insertion force or removal force, to engage or disengage the connectors of the top and bottom units. In the new computer system, the connecting blades are now divided into the top connecting blades and the bottom connecting blades. Thus, the height of the connecting blades is reduced so that they are easier to handle. Further, as the connecting blades are either connected to the top horizontal blades or the bottom horizontal blades, fewer connectors are engaged or disengaged when a connecting blade is inserted or removed and thus the insertion force or removal force is reduced. By this, the replacement of the connecting blades is further improved.

Further, the electronic components of the horizontal blades and the electronic components of the vertical blades are connected in a leaf-spine topology via the connecting blades, wherein each horizontal blade comprises at least one leaf component and each vertical blade comprises at least one spine component, wherein each leaf component is connected to each spine component via the connecting blades. In particular, each one of one or more leaf components on each horizontal blade may be connected to each one of one or more spine components on each vertical blade. A leaf-spine topology is an interconnect design used in data centers to optimize traffic flow, reduce latency, and provide high scalability. It comprises two layers, namely a leaf layer and a spine layer. The leaf layer comprises leaf components. The spine layer comprises spine components. The leaf components may comprise computing units. The spine components may comprise switches or switch chips that interconnect the leaf components. Each leaf component connects to every spine component in the arrangement, ensuring multiple paths for data traffic from leaf to leaf.

Further, each horizontal blade comprises one or more computing chips and each vertical blade may comprise one or more switch chips, wherein each computing chip is a leaf component and each switch chip is a spine component. With other words, each leaf component is a computing chip and each spine component is a switch chip (also called fabric chip). The computing chip may be a CPU (central processing unit) chip or an Artificial Intelligence (AI) accelerator chip.

Accordingly, the objective technical problem is fully solved.

In a preferred refinement, each horizontal blade may comprise a plurality of horizontal-blade connectors, wherein each vertical blade comprises a plurality of vertical-blade connectors, wherein the vertical-blade connectors comprise top vertical-blade connectors and bottom vertical-blade connectors, wherein each top connecting blade is configured to establish communication connections from a horizontal-blade connector of each top horizontal blade to the top vertical-blade connectors of the corresponding vertical blade, wherein each bottom connecting blade is configured to establish communication connections from a horizontal-blade connector of each bottom horizontal blade to the bottom vertical-blade connector of the corresponding vertical blade, in particular wherein the established communication connections are optical and/or electrical connections.

The horizontal and vertical blades have respective connectors for establishing the communication connections via the connecting blades. The established communication connections may be signal connections. Preferably, the connections are electrical connections. Alternatively, the connections may be optical connections. By the established communication connections, signals may be transferred between the horizontal and vertical blades. In each vertical blade, the vertical-blade connectors may be distributed in the height direction. In each horizontal blade, the horizontal-blade connectors may be distributed in the width direction.

In a further refinement, each connecting blade comprises a plurality of connecting-blade connectors, wherein the connecting-blade connectors comprise first connecting-blade connectors and one or more second connecting-blade connectors, wherein each first connecting-blade connector connects with a respective horizontal-blade connector, wherein each second connecting-blade connector connects with a respective vertical-blade connector.

The connecting-blade connectors of a connecting blade serve for connecting with the corresponding vertical blade and the corresponding horizontal blades to establish the communication connections therebetween. For this, each first connecting-blade connector may be connected to one of the second connecting-blade connectors. The connecting-blade connectors may be distributed in the height direction. In each top connecting blade, the first connecting-blade connectors may be arranged above the second connecting-blade connectors. In each bottom connecting blade, the first connecting-blade connectors may be arranged below the second connecting-blade connectors.

In a further refinement, each horizontal blade, each vertical blade and/or each connecting blade may comprise a housing, wherein the respective connectors are mounted in a fixed position with respect to the housing.

For instance, the connectors may be directly mounted to the housing. Alternatively, the connectors may be mounted to a component, for example a PCB board, that is further mounted to the housing. In each horizontal blade, the horizontal-blade connectors may be mounted in a fixed position with respect to the housing of the horizontal blade. In each vertical blade, the vertical-blade connectors may be mounted in a fixed position with respect to the housing of the vertical blade. In each connecting blade, the connecting-blade connectors may be mounted in a fixed position with respect to the housing of the connecting blade.

In a further refinement, each connecting blade may comprise a PCB board to implement the respective connections between the respective horizontal blades and the corresponding vertical blade.

By this, the size of the connecting blades may be further reduced. A PCB board is a printed circuit board. The PCB board may comprise a plurality of traces for implementing the respective connections between the respective horizontal blades and the corresponding vertical blade. Each trace establishes a connection between a horizontal-blade connector of the respective horizontal blades and a vertical-blade connector of the corresponding vertical blade. In particular, ends of the traces may be attached and electrically connected to the respective connecting-blade connectors.

In a further refinement, a board plane of each PCB board may be parallel to a connection plane between the connecting blades and the horizontal and vertical blades.

With other words, the board plane may be arranged perpendicular to the length direction. The traces may run parallel to, in particular in, the board plane. The horizontal-blade connectors and the vertical-blade connectors may connect with connecting-blade connectors in the connection plane.

In an alternative refinement, a board plane of each PCB board may be orthogonal to a connection plane between the connecting blades and the horizontal and vertical blades.

With other words, the board plane may be arranged parallel to the length direction. Preferably, the board plane is arranged perpendicular to the width direction.

In a further refinement, each connecting blade may comprise one or more cables to implement the respective connections between the respective horizontal blades and the corresponding vertical blade.

By this, the communication performance of the established communication connection between the horizontal blades and the vertical blades is further improved. Each cable may establish a connection between a horizontal-blade connector of the respective horizontal blades and a vertical-blade connector of the corresponding vertical blade. In particular, ends of the cables may be attached and electrically or optically connected to the respective connecting-blade connectors.

In a further refinement, the horizontal-blade connectors and vertical-blade connectors use optical signaling, wherein the one or more cables of each connecting blade comprise optical fibers, in particular from each horizontal-blade connector to its corresponding vertical-blade connector.

By this, the communication performance is even further improved.

In a further refinement, each connecting blade may comprise one or more multiheaded cables, wherein each multiheaded cable is formed by two or more of the cables, wherein each multiheaded cable connects a respective vertical-blade connector of the corresponding vertical blade to two or more horizontal-blade connectors of the respective horizontal blades.

By this, the cables and the connectors can be provided in the connecting blades in a more compact manner, thereby allowing to reduce the size of the connecting blades.

In a further refinement, each horizontal blade may comprise a memory and/or one or more expansion devices, in particular wherein, in each horizontal blade, the memory and/or the one or more expansion devices are connected to the computing chip.

In particular, the memory and/or the one or more expansion devices may be attached to the computing chip. The one or more expansion devices may comprise at least one of a storage Expansion (such as an HDD), a PCIe card (such as a GPU), an external device (such as an external GPU), an I/O Expansion (such as an USB port), or a specialized hardware (such as a FPGA).

In a further refinement, the number of the top horizontal blades may be the same as or may be different than the number of the bottom horizontal blades.

For example, there may be four vertical blades, four top horizontal blades, four bottom horizontal blades, four top connecting blades and four bottom connecting blades.

In a further refinement, the computer system comprises a rack, wherein the horizontal blades, the vertical blades and the connecting blades are arranged in the rack.

The rack may be a server rack. The rack may be arranged in a data center. The reference system may be defined with respect to the rack. The rack comprises a front side and a rear side. The horizontal blades and the vertical blades are arranged at the front side of the rack and the connecting blades are arranged at the rear side of the rack.

In a further refinement, the rack may include a plurality of front slots for the horizontal blades and the vertical blades and a plurality of rear slots for the connecting blades.

The horizontal blades and the vertical blades may be arranged, in particular inserted, in the front slots. The connecting blades may be arranged, in particular inserted, in the rear slots. The rack may comprise an additional frame or housing for forming the slots for the vertical blades between the slots for the horizontal blades.

In a further refinement, each horizontal blade, each vertical blade and/or each connecting blade may be insertable into the respective slot of the rack, in particular for establishing the respective connections between the horizontal blades, the vertical blades and the connecting blades.

By this, each blade can be independently inserted into and removed from the rack. Thereby, replacement of the blades is further facilitated.

In a further refinement, each vertical blade may be connected to two top connecting blades and two bottom connecting blades.

In particular, each of the two top connecting blades may connect the corresponding vertical blade to each of the top horizontal blades and each of the two bottom connecting blades may connect the corresponding vertical blade to each of the bottom horizontal blades. In this case, the number of top connecting blades may be twice the number of vertical blades and the number of bottom connecting blades may be twice the number of vertical blades. Preferably, a width of each vertical blade may be twice as wide as the width of each connecting blade. With other words, for each vertical blade, there may be an additional second top connecting blade connecting the vertical blade to each horizontal blade above, and there may be an additional second bottom connecting blade connecting the vertical blade to each horizontal blade below. For example, there may be four vertical blades, four top horizontal blades, four bottom horizontal blades, eight top connecting blades and eight bottom connecting blades.

In a further refinement, each vertical blade and/or each horizontal blade and/or each connecting blade may comprise one or more cooling fans, in particular wherein the cooling fans are configured to generate a cooling airflow from the front side to the rear side, preferably at least through the horizontal blades and/or the vertical blades.

By this, the cooling efficiency is further improved.

In a further refinement, a length of each connecting blade in the length direction may be smaller than a length of each horizontal blade and each vertical blade.

With other words, each horizontal blade and each vertical blade have a length that is larger than the length of each connecting blade. By this, the compactness of the computer system is improved.

In a further refinement, the computer system may comprise a first gap between two adjacent top connecting blades and a second gap between two adjacent bottom connecting blades.

With other words, the top connecting blades may be arranged in the width direction so that the first gap is formed between the two adjacent top connecting blades. The bottom connecting blades may be arranged in the width direction so that the second gap is formed between the two adjacent bottom connecting blades. In the width direction, the width of each horizontal blade is greater than the sum of the widths of the top connecting blades. In the width direction, the width of each horizontal blade is greater than the sum of the widths of the bottom connecting blades. The two gaps improve the cooling airflow from the front side to the rear side, especially for cooling the electronic components of the horizontal blades. Thereby, the cooling efficiency is further improved.

In a further refinement, the first gap and the second gap may be aligned in the height direction.

By aligning the first gap and the second gap, a continuous gap is formed at the rear side, in particular extending from the top to the bottom of the rack. Preferably, the first gap and the second gap may be centered in the width direction. With other words, the first gap may be arranged in the width direction such that the first half of the top connecting blades is arranged on one side and the second half of the top connecting blades is arranged on the other side of the first gap. The second gap may be arranged in the width direction such that the first half of the bottom connecting blades is arranged on one side and the second half of the bottom connecting blades is arranged on the opposite side of the second gap. By this, cooling airflow from the front side to the rear side is further improved. Thereby, the cooling efficiency is further improved.

It goes without saying that the features mentioned above and those yet to be explained below cannot only be used in the respective combinations disclosed, but also in different combinations or alone without departing from the scope of the present invention.

### Brief description of the drawings

Further features and advantages will be apparent from the following detailed description. Unless otherwise defined, all technical and scientific terms have the meaning as commonly understood by one of ordinary skill in the art. In the drawings:
- Fig. 1: shows an isometric illustration of an exemplary embodiment of a computer system, without showing the chassis or rack holding the blades;
- Fig. 2: shows an isometric illustration of the computer system of Fig. 1 from a rear side;
- Fig. 3: shows a side view of the computer system of Fig. 1;
- Fig. 4 (A): shows an isometric illustration of an example of a horizontal blade, wherein its housing is only partly shown;
- Fig. 4 (B): shows a simplified schematic illustration of a top view of the horizontal blade of Fig. 4 (A);
- Fig. 5 (A): shows an isometric illustration of an example of a vertical blade, wherein its housing is only partly shown;
- Fig. 5 (B): shows a simplified schematic illustration of a top view of the vertical blade of Fig. 5 (A);
- Fig. 6 (A): shows a simplified schematic illustration of a front view of a first example of a connecting blade;
- Fig. 6 (B): shows an illustration of a rear view of the connecting blade of Fig. 6 (A);
- Fig. 7: shows an illustration of a side view of the connecting blade of Fig. 6 (A), wherein its housing is only partly shown;
- Fig. 8: shows an isometric illustration of an example of a multiheaded cable;
- Fig. 9 (A): shows an isometric illustration of a second example of a connecting blade;
- Fig. 9 (B): shows a simplified schematic illustration of PCB board of the connecting blade of Fig. 9 (A);
- Fig. 10: shows an isometric illustration of the computer system of Fig. 1 from a rear side with partly opened connecting blades, wherein the housing of each connecting blade is only partly shown;
- Fig. 11: shows an isometric illustration of the computer system of Fig. 1 from a rear side with fully opened connecting blades, wherein the housing of each connecting blade is not shown;
- Fig. 12: shows a side view of the computer system of Fig. 1 with partly opened vertical blade and fully opened connecting blades, wherein the housing of the vertical blade is only partly shown and the housing of each connecting blade is not shown;
- Fig. 13: shows a simplified illustration of an arrangement of connectors of horizontal and vertical blades of the computer system of Fig. 1 in a connection plane; and
- Fig. 14: shows the illustration of Fig. 13 with established orthogonal connection via cables within the connecting blades.

### Detailed description of the embodiments

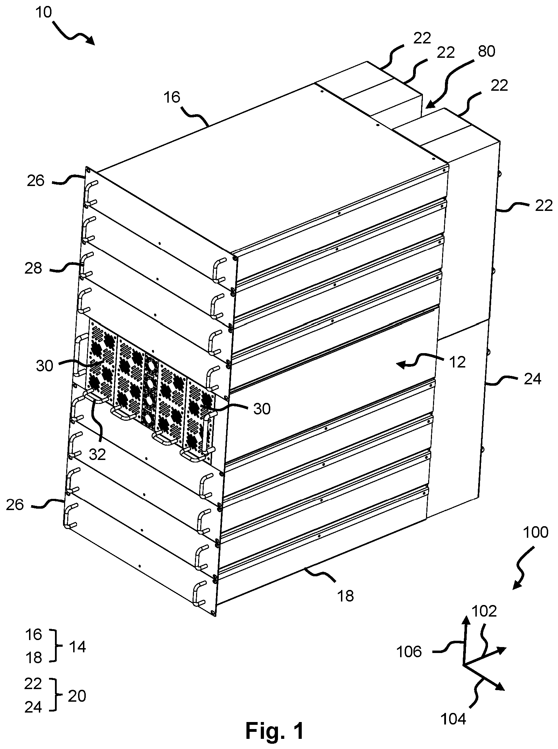

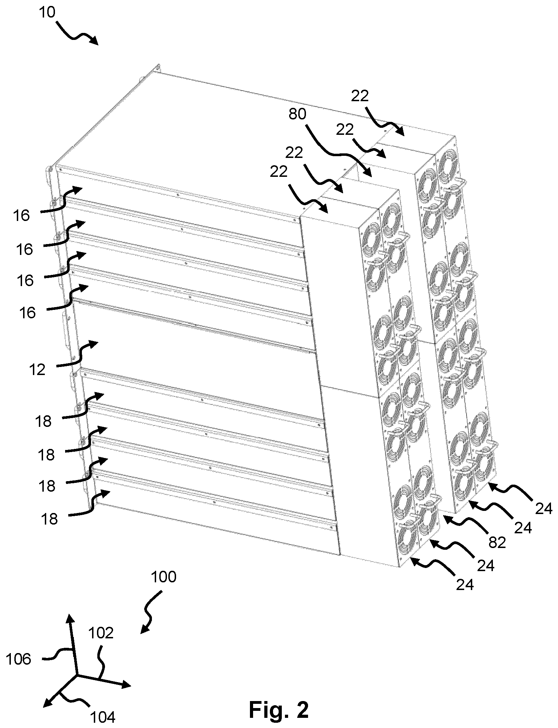

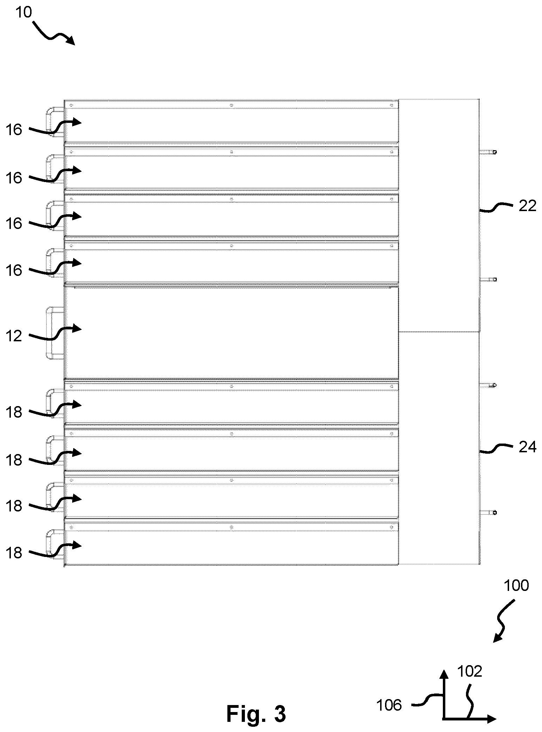

In Figures 1 to 3, an exemplary embodiment of the new computer system is shown designated by reference number 10 in its entirety.

The components of computer system 10 are arranged with respect to a reference system 100. The reference system 100 is a cartesian coordinate system. The reference system comprises a length direction 102, a width direction 104 and a height direction 106. The length direction 102, the width direction 104 and the height direction 106 are perpendicular to each other.

The computer system 10 comprises a plurality of vertical blades 12 and a plurality of horizontal blades 14. Preferably, the number of vertical blades 12 is four and the number of horizontal blades 14 is eight. The horizontal blades 14 comprise top horizontal blades 16 and bottom horizontal blades 18. Preferably, the number of top horizontal blades 16 may be equal to the number of bottom horizontal blades 18. For instance, the horizontal blades 14 may comprise four top horizontal blades 16 and four bottom horizontal blades 18. Alternatively, the number of top horizontal blades 16 may be different than the number of bottom horizontal blades 18.

The computer system 10 comprises a plurality of connecting blades 20. The connecting blades 20 comprise top connecting blades 22 and bottom connecting blades 24. Each top connecting blade 22 corresponds to a respective vertical blade 12. Each bottom connecting blade 24 corresponds to a respective vertical blade 12. Preferably, one top and one bottom connecting blade 22, 24 may correspond to a respective vertical blade 12. In this case, the number of top connecting blades 22 and the number of bottom connecting blades 24 is equal to the number of vertical blades 12. For example, in case of four vertical blades 12, there may be four top connecting blades 22 and four bottom connecting blades 24 so that the number of connecting blades 20 may be eight in total. Alternatively, two top and two bottom connecting blades 22, 24 may correspond to a respective vertical blade 12. In this case, the number of top connecting blades 22 and the number of bottom connecting blades 24 is twice the number of vertical blades 12. For example, in case of four vertical blades 12, there may be eight top connecting blades 22 and eight bottom connecting blades 24 so that the number of connecting blades 20 may be sixteen in total.

In the length direction 102, each blade 12, 14, 20 comprises a front side and a rear side. Each blade 12, 14, 20 comprises a length in the length direction 102, a width in the width direction 104 and a height in the height direction 106. In the length direction 102, the length of each connecting blade 20 may be smaller than the length of each horizontal blade 14 and each vertical blade 12.

In the height direction 106, the top horizontal blades 16 are arranged above vertical blades 12 and the bottom horizontal blades 18 are arranged below vertical blades 12. With other words, the vertical blades 12 are arranged between the top horizontal blades 16 and the bottom horizontal blades 18. The vertical blades 12 are distributed in the width direction 104. In particular, the vertical blades 12 are stacked in the width direction 104. The top horizontal blades 16 are distributed in the height direction 106. In particular, the top horizontal blades 16 are stacked over each other in the height direction 106. The bottom horizontal blades 18 are distributed in the height direction 106. In particular, the bottom horizontal blades 18 are stacked over each other in the height direction 106.

In the height direction 106, the top connecting blades 22 are arranged above the bottom connecting blades 24. The top connecting blades 22 are distributed in the width direction 104. In particular, the top connecting blades 22 are stacked over each other in the width direction 104. The bottom connecting blades 24 are distributed in the width direction 104. In particular, the bottom connecting blades 24 are stacked over each other in the width direction 104.

In the length direction 102, the vertical blades 12 and the horizontal blades 14 are arranged on a front side and the connecting blades 20 are arranged on a rear side. In the length direction 102, the horizontal and vertical blades 12, 14 are arranged in front of the connecting blades 20. The rear sides of each horizontal blade and each vertical blade may be aligned to each other, in particular with respect to a connection plane.

In the width direction 104, the width of each horizontal blade 14 is greater than the sum of the widths of the vertical blades 12. In the width direction 104, the width of each horizontal blade 14 is greater than the sum of the widths of the vertical blades 12. In the width direction 104, the width of each horizontal blade 14 is greater than the sum of the widths of the top connecting blades 22. In the width direction 104, the width of each horizontal blade 14 is greater than the sum of the widths of the bottom connecting blades 24. In the width direction 104, the width of each vertical blade 12 may be the equal to the width of each connecting blade 20.

A connection plane is arranged between the horizontal and vertical blades 12, 14 and the connecting blades 20. The connection plane is arranged perpendicular to the length direction 102. The rear sides of each horizontal and vertical blade 12, 14 are aligned to each other, in particular with respect to the connection plane. The front sides of the connecting blades 20 are aligned to each other, in particular with respect to the connection plane. The rear sides of each vertical and horizontal blade 12, 14 and the front sides of each connecting blade 20 are arranged at the connection plane.

By the connecting blades 20, an orthogonal connection is established between the horizontal blades 14 and the vertical blades 12. Each top connecting blade 22 is connected to the corresponding vertical blade 12 and to each top horizontal blade 16. Each bottom connecting blade 24 is connected to the corresponding vertical blade 12 and to each bottom horizontal blade 18. By this, each top connecting blade 22 connects each top horizontal blade 16 to the corresponding vertical blade 12. Each bottom connecting blade 14 connects each bottom horizontal blade 18 to the corresponding vertical blade 12.

Each vertical blade 12 and each horizontal blade 14 comprises one or more electronic components. For example, each horizontal blade 14 may comprise a computing unit, in particular a computing chip. Each vertical blade 12 may comprise a switch unit, in particular a switch chip. By the orthogonal connection, the electronic components of the horizontal blades and the electronic components of the vertical blades may be connected in a leaf-spine topology, in particular via the connecting blades 20. Each horizontal blade comprises at least one leaf component and each vertical blade comprises at least one spine component. Each leaf component is connected to each spine component, in particular via the connecting blades 20. In particular, the electronic components of the horizontal blades 14 comprise the leaf components and the electronic components of the vertical blades 12 comprise the spine components. For example, each horizontal blade 14 may comprise one or more computing chips and each vertical blade 12 may comprise one or more switch chips, wherein each computing chip may be a leaf component and each switch chip may be a spine component.

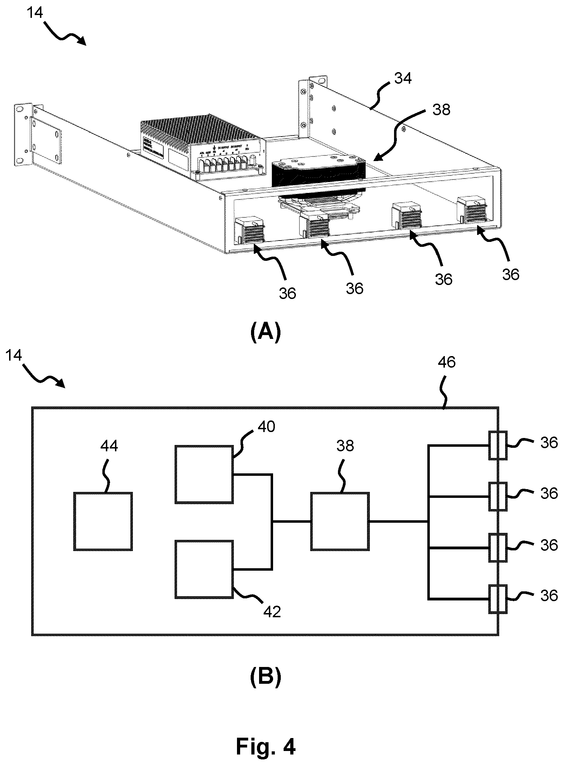

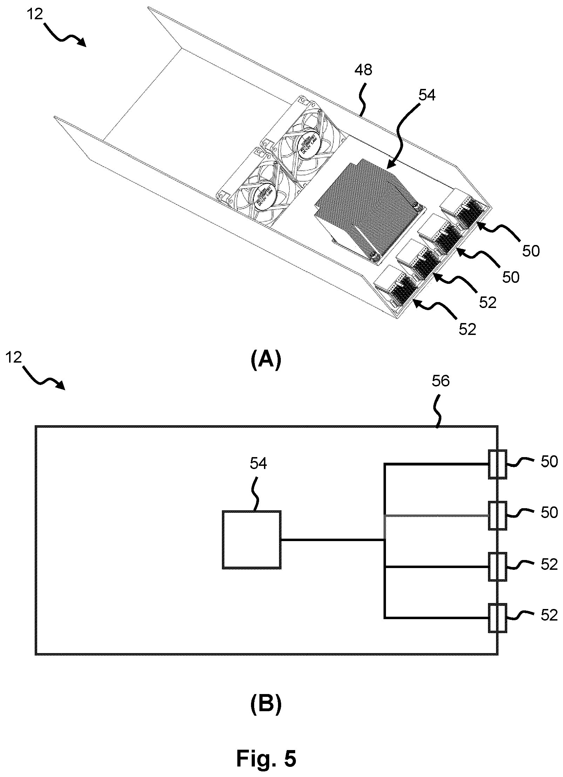

Each horizontal blade 14 comprises one or more handles 28. Each handle 28 is arranged on, in particular mounted to, a front side 26 of a housing of the respective horizontal blade 14. The housing of each horizontal blade 14 is described in more detail with respect to Figs. 4 (A) and (B) below. Each vertical blade 12 comprises one or more handles 32. Each handle 32 is arranged on, in particular mounted to, a front side 30 of a housing of the respective vertical blade 12. The housing of each vertical blade 12 is described in more detail with respect to Figs. 5 (A) and (B) below.

The computer system may comprise a rack (not shown in Fig. 1). The reference system 100 may be defined with respect to the rack. The horizontal blades 14, the vertical blades 12 and the connecting blades 20 may be arranged in the rack. In the length direction 102, the rack may comprise a front side and a rear side. The rack may include a plurality of front slots for the horizontal blades 14 and the vertical blades 12 and a plurality of rear slots for the connecting blades 20. The front slots may be on the front side of the rack. The rear slots may be on the rear side of the rack. Each horizontal blade 14, each vertical blade 12 and/or each connecting blade 20 may be insertable into the respective slot of the rack, in particular for establishing the respective connections between the horizontal blades 14, the vertical blades 12 and the connecting blades 20.

Each vertical blade 12 and/or each horizontal blade 14 and/or each connecting blade 20 may comprise one or more cooling fans. The cooling fans may be configured to generate a cooling airflow from the front side to the rear side, preferably at least through the horizontal blades 14 and/or the vertical blades 12 for cooling the electronic components of the horizontal and vertical blades 12, 14.

The computer system 10 may comprise a first gap 80 between two adjacent top connecting blades 22 and a second gap 82 between two adjacent bottom connecting blades 24. The first gap 82 and the second gap 84 may be aligned in the height direction 106. Preferably, the first gap 80 and the second gap 82 may be centered in the width direction 104.

In Figures 4 (A) and 4 (B), an example of a horizontal blade 14 is shown. The horizontal blades 14 of the computer system 10 may be configured according to this example.

The horizontal blade 14 comprises a housing 34 and horizontal-blade connectors 36. The horizontal-blade connectors 36 are mounted in a fixed position with respect to the housing 34. Preferably, the horizontal-blade connectors 36 are accessible from the rear side of the horizontal blade 14. In particular, the horizontal-blade connectors 36 may be arranged at the rear side of the horizontal blade 14. The horizontal blade 14 comprises one or more computing chips 38. The computing chip may be a leaf component. The computing chips 38 may be connected to the horizontal-blade connectors 36. The horizontal blade 14 may comprise a memory 40 and/or one or more expansion devices 42. The memory 40 and/or the one or more expansion devices 42 may be connected to the computing chip 38.

The horizontal blade 14 may comprise a power connector for providing electrical power from an external power supply. Additionally or alternatively, the horizontal blade 14 may comprise a power supply device 44 that provides electrical power for the electronic components of the horizontal blade 14. The power supply device 44 may be connected to the external power supply via the power connector.

The horizontal blade 14 may comprise a PCB board 46. The PCB board 46 may be mounted to the housing 34. The horizontal-blade connectors 36 may be mounted to the PCB board 46. The computing chip 38 may be mounted to the PCB board 46. Further, the memory 40, the expansion device and/or the power supply device may be mounted to the PCB board 46.

Preferably, the housing 34 is provided on all six sides of the horizontal blade 14. In particular, the housing 34 may fully enclose an internal space of the horizontal blade 14. The one or more computing chips 38, the memory 40 and the PCB board 46 may be arranged in the internal space.

In Figures 5 (A) and 5 (B), an example of a vertical blade 12 is shown. The vertical blades 12 of the computer system 10 may be configured according to this example.

The vertical blade 12 comprises a housing 48 and a plurality of vertical-blade connectors 50, 52. The vertical-blade connectors 50, 52 comprise top vertical-blade connectors 50 and bottom vertical-blade connectors 52. In the height direction 106, the top vertical-blade connectors 50 are arranged above the bottom vertical-blade connectors 52. The vertical-blade connectors 50, 52 are mounted in a fixed position with respect to the housing 48. Preferably, the vertical-blade connectors 50, 52 are accessible from the rear side of the vertical blade 12. In particular, the vertical-blade connectors 50, 52 may be arranged at the rear side of the vertical blade 12.

The vertical blade 12 may additionally comprise a power connector for providing electrical power from an external power supply. Additionally or alternatively, the vertical blade 12 may comprise a power supply device that provides electrical power for the electronic components of the vertical blade 12. The power supply device of the vertical blade may be connected to the external power supply via the power connector.

The vertical blade 12 comprises one or more switch chips 54. The switch chip 54 may be a spine component. The switch chips 54 is connected to the vertical-blade connectors 50, 52. The vertical blade 12 may comprise a PCB board 56. The switch chip 54 may be mounted to the PCB board 56. The vertical-blade connectors 50, 52 may be mounted to the PCB board 56. The PCB board 56 may be mounted to the housing 48.

Preferably, the housing 48 is provided on all six sides of the vertical blade 12. In particular, the housing 48 may fully enclose an internal space of the vertical blade 12. The one or more switch chips 54 and the PCB board 56 may be arranged inside the internal space.

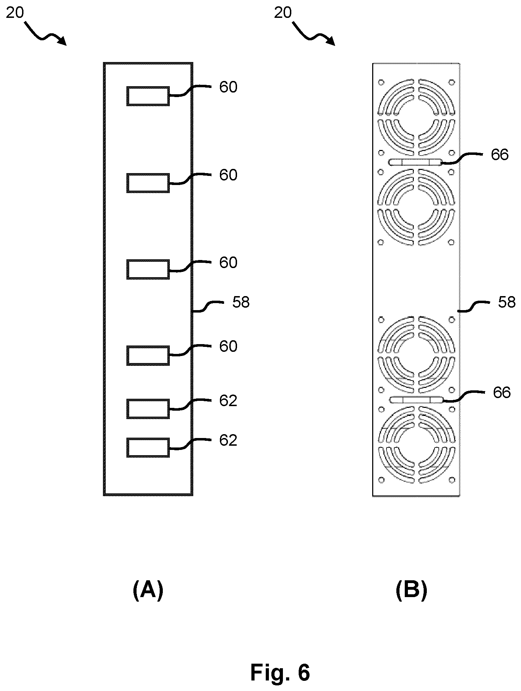

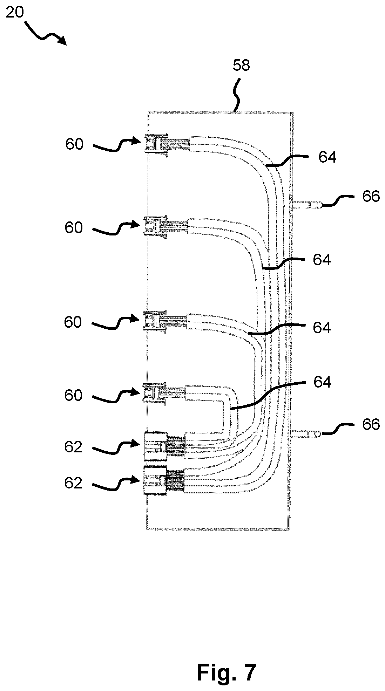

In Figures 6 (A), 6 (B) and 7, a first example of a connecting blade 20 is shown. The connecting blades 20 of the computer system 10 may be configured according to this first example.

The connecting blade 20 comprises a housing 58 and a plurality of connecting-blade connectors 60, 62. The connecting-blade connectors 60, 62 comprise first connecting-blade connectors 60 and one or more second connecting-blade connectors 62. The connecting-blade connectors 60, 62 are mounted in a fixed position with respect to the housing 34.

The connecting blade 20 comprises one or more cables 64. In particular, the cables 64 are configured to implement the respective connections between the respective horizontal blades 14 and the corresponding vertical blade 12. The cables 64 connect each first connecting-blade connector 60 to one of the second connecting-blade connectors 62. In particular, each cable 64 has a first end connected to the respective first connecting-blade connector 60 and a second end connected to the respective second connecting-blade connectors 62. For example, the connecting blade 20 comprises four cables.

Preferably, the connecting blade 20 comprises one or more multiheaded cables, wherein each multiheaded cable is formed by two or more of the cables 64. In a multiheaded cable, the first ends of the cables 64 are connected to different first connecting-blade connectors 60 and the second ends of the cables 64 are connected to the same second connecting-blade connector 62. With other words, each multiheaded cable connects one second connecting-blade connector 62 to two or more first connecting-blade connectors 60. Thus, each multiheaded cable connects one vertical-blade connector 50, 52 to two or more horizontal-blade connectors 36.

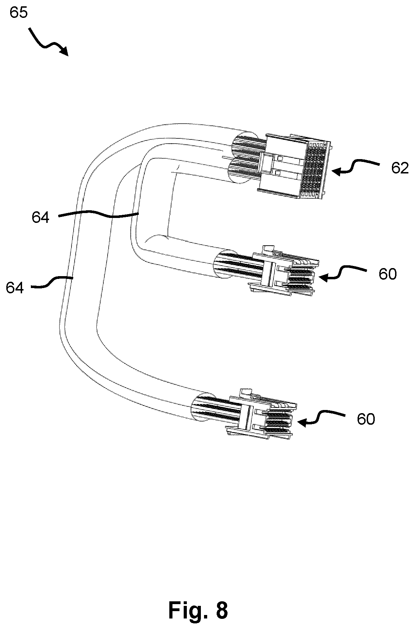

Preferably, each multiheaded cable is formed by two cables 64. For example, the connecting blade 20 may comprise two multiheaded cables, each formed by two cables 64. For instance, Fig. 8 shows an example of a multiheaded cable 65 formed by two cables 64. Alternatively, each multiheaded cable is formed by more than two cables 64, in particular by four cables 64. For example, the connecting blade 20 may comprise one multiheaded cable formed by four cables 64.

For instance, the horizontal-blade connectors 36 and vertical-blade connectors 50, 52 may use optical signaling. In this case, the one or more cables 64 of each connecting blade 20 may comprise optical fibers. Alternatively, the horizontal-blade connectors 36 and vertical-blade connectors 50, 52 may use electrical signaling. In this case, the one or more cables 64 comprise one or more wires.

Preferably, the housing 58 is provided on all six sides of the connecting blade 20. In particular, the housing 58 may fully enclose an internal space of the connecting blade 20. The cables 64 may be arranged inside the internal space.

The connecting blade 20 may further comprise a handle 66. The handle 66 is mounted on the rear side of the connecting blade 20.

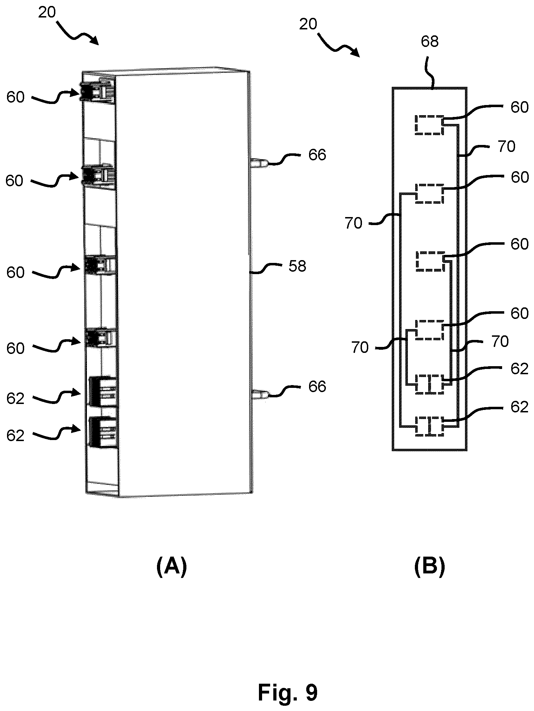

In Figures 9 (A) and 9 (B), a second example of a connecting blade 20 is shown. The connecting blades 20 of the computer system 10 may be configured according to this second example. The configuration of the connecting blade 20 of the second example is substantially the same as the configuration of the connecting blade 20 of the first example. The same elements are designated with the same reference numerals and are not described in more detail. The configuration of the connecting blade 20 of the second example differs from the first example in the implementation of the connections.

The connecting blade 20 comprises a PCB board 68. The PCB board has a board plane. The board plane is arranged perpendicular to the length direction 102 and thus is arranged parallel to the connection plane. The connecting-blade connectors 60, 62 are mounted to the PCB board 68. Alternatively, the board plane may be arranged parallel to the length direction 102 and thus may be arranged perpendicular to the connection plane. The latter alternative likely offers more space for front-to-rear airflow and thus better cooling of the computer system 10.

The PCB board 68 is configured to implement the respective connections between the respective horizontal blades 14 and the corresponding vertical blade 12. The PCB board 68 may comprise a plurality of traces 70 where each trace 70 comprises many separate parallel electrical signals. By the traces 70, the respective connections are implemented. In particular, each trace 70 establishes a connection between a horizontal-blade connector 36 and a vertical-blade connector 50, 52. The traces 70 connect each first connecting-blade connector 60 to one of the second connecting-blade connectors 62. In particular, each trace 70 has a first end connected to the respective first connecting-blade connector 60 and a second end connected to the respective second connecting-blade connectors 62. For example, the connecting blade 20 may comprise four traces.

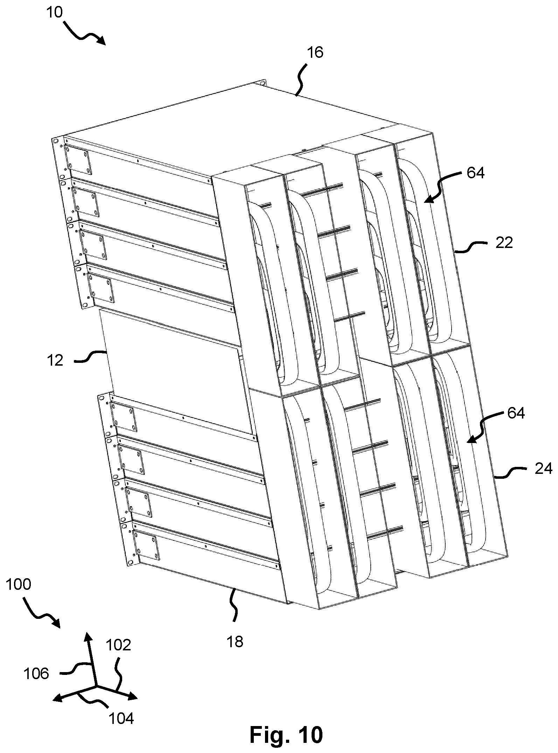

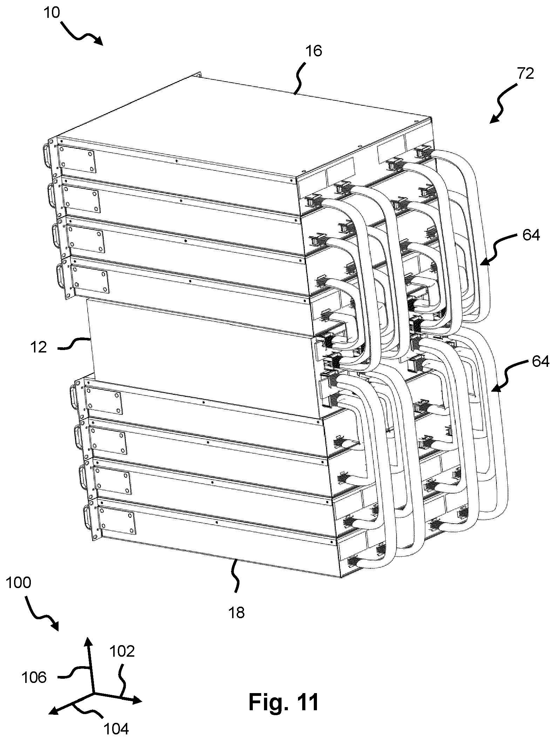

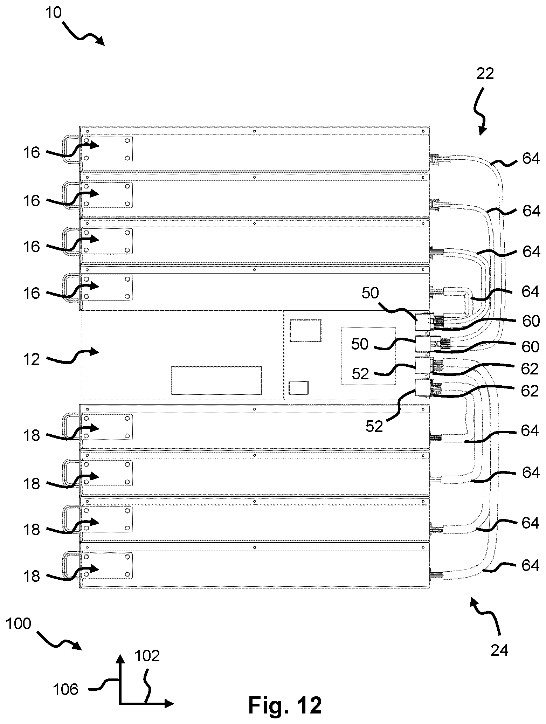

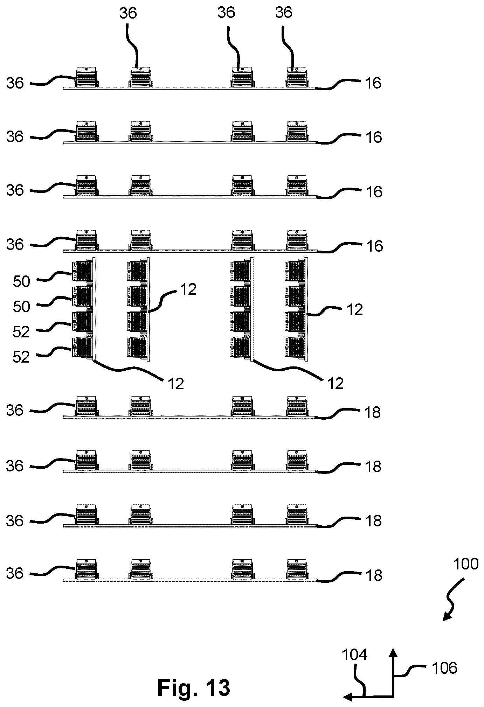

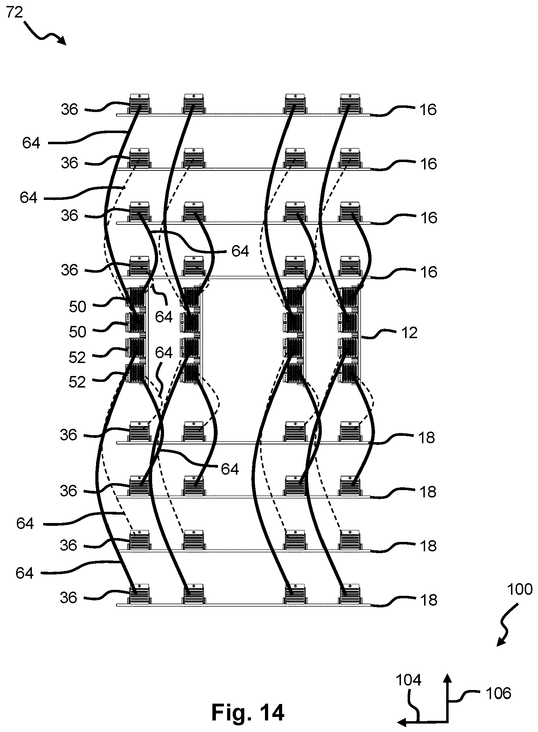

In Figs. 10 to 15, the connection between the blades 12, 14, 20, especially via their connectors 36, 50, 52, 60, 62, are shown in more detail.

The horizontal-blade connectors 36 are distributed in width direction 104. The vertical-blade connectors 50, 52 are distributed in height direction 106. In the height direction 106, the top vertical-blade connectors 50 are arranged above the bottom vertical-blade connectors 52. The connecting-blade connectors 60, 62 are distributed in the height direction 106. In each top connecting blade 22, the first connecting-blade connectors 60 are arranged above the second connecting-blade connectors 62 in the height direction 106. In each bottom connecting blade 24, the first connecting-blade connectors 60 are arranged below the second connecting-blade connectors 62 in the height direction 106.

Each top connecting blade 22 is configured to establish communication connections from a horizontal-blade connector 36 of each top horizontal blade 16 to the top vertical-blade connectors 50 of the corresponding vertical blade 14. Each bottom connecting blade 24 is configured to establish communication connections from a horizontal-blade connector 36 of each bottom horizontal blade 18 to the bottom vertical-blade connector 52 of the corresponding vertical blade 14. In particular, each horizontal-blade connector 36 is connected to a corresponding first connecting-blade connector 58. Each vertical-blade connector 50 is connected to a corresponding second connecting-blade connector 60. By this, an orthogonal connection 72 is established between each horizontal blade 14 and each vertical blade 12 via the connecting blades 20. The connectors 36, 60 connect with each other in the connection plane and the connectors 50, 62 also connect with each other in the connection plane. The established communication connections may be optical and/or electrical connections.

## Claims

1. A computer system (10), wherein the computer system (10) comprises:
- a plurality of vertical blades (12);
- a plurality of horizontal blades (14), the horizontal blades (14) comprising top horizontal blades (16) and bottom horizontal blades (18), the top horizontal blades (16) being arranged above the vertical blades (12), the bottom horizontal blades (18) being arranged below the vertical blades (12); and
- a plurality of connecting blades (20), the connecting blades (20) comprising top connecting blades (22) and bottom connecting blades (24),
wherein each top connecting blade (22) is connected to one of the vertical blades (12) and to each top horizontal blade (16), wherein each bottom connecting blade (24) is connected to one of the vertical blades (12) and to each bottom horizontal blade (18),
wherein each horizontal blade (14) and each vertical blade (12) comprises at least one electronic component, wherein the electronic components of the horizontal blades (14) and the electronic components of the vertical blades (12) are connected in a leaf-spine topology via the connecting blades (20), wherein each horizontal blade (14) comprises at least one leaf component and each vertical blade (12) comprises at least one spine component, wherein each leaf component is connected to each spine component via the connecting blades (20), wherein each horizontal blade (14) comprises one or more computing chips (38) and each vertical blade (12) comprises one or more switch chips (54), wherein each computing chip (38) is a leaf component and each switch chip (54) is a spine component.

2. The computer system (10) according to claim 1, wherein each horizontal blade (14) comprises a plurality of horizontal-blade connectors (36), wherein each vertical blade (12) comprises a plurality of vertical-blade connectors (50, 52), wherein the vertical-blade connectors (50, 52) comprise top vertical-blade connectors (50) and bottom vertical-blade connectors (52), wherein each top connecting blade (22) is configured to establish communication connections from a horizontal-blade connector (36) of each top horizontal blade (16) to the top vertical-blade connectors (50) of the corresponding vertical blade (12), wherein each bottom connecting blade (24) is configured to establish communication connections from a horizontal-blade connector (36) of each bottom horizontal blade (18) to the bottom vertical-blade connector (52) of the corresponding vertical blade (12), in particular wherein the established communication connections are optical and/or electrical connections.

3. The computer system (10) according to claim 2, wherein each connecting blade (20) comprises a plurality of connecting-blade connectors (60, 62), wherein the connecting-blade connectors (60, 62) comprise first connecting-blade connectors (60) and one or more second connecting-blade connectors (62), wherein each first connecting-blade connector (60) connects with a respective horizontal-blade connector (36), wherein each second connecting-blade connector (62) connects with a respective vertical-blade connector (50, 52).

4. The computer system (10) according to claim 2 or 3, wherein each horizontal blade (14), each vertical blade (12) and/or each connecting blade (20) comprises a housing (34, 48, 58), wherein the respective connectors (36, 50, 52, 60, 62) are mounted in a fixed position with respect to the housing (34, 48, 58).

5. The computer system (10) according to any one of claims 2 to 4, wherein each connecting blade (20) comprises a PCB board (68) to implement respective communication connections between the respective horizontal blades (14) and the corresponding vertical blade (12), in particular wherein a board plane of each PCB board (68) is parallel or orthogonal to a connection plane between the connecting blades (20) and the horizontal and vertical blades (12, 14).

6. The computer system (10) according to any one of claims 2 to 4, wherein each connecting blade (20) comprises one or more cables (64) to implement the respective communication connections between the respective horizontal blades (14) and the corresponding vertical blade (12).

7. The computer system (10) according to claim 6, wherein the horizontal-blade connectors (36) and vertical-blade connectors (50, 52) use optical signaling, wherein the one or more cables (64) of each connecting blade (20) comprise optical fibers, in particular from each horizontal-blade connector (36) to its corresponding vertical-blade connector (50, 52).

8. The computer system (10) according to claim 6 or 7, wherein each connecting blade (20) comprises one or more multiheaded cables, wherein each multiheaded cable is formed by two or more of the cables (64), wherein each multiheaded cable connects a respective vertical-blade connector (50, 52) of the corresponding vertical blade (12) to a horizontal-blade connector (36) of two or more of the respective horizontal blades (14).

9. The computer system (10) according to any one of claims 1 to 8, wherein each horizontal blade (14) comprises a memory (40) and/or one or more expansion devices (42), in particular wherein, in each horizontal blade (14), the memory (40) and/or the one or more expansion devices (42) are connected to the computing chip (38).

10. The computer system (10) according to any one of claims 1 to 9, wherein the number of the top horizontal blades (16) is the same as or is different than the number of the bottom horizontal blades (18).

11. The computer system (10) according to any one of claims 1 to 10, wherein the computer system (10) comprises a rack, wherein the horizontal blades (14), the vertical blades (12) and the connecting blades (20) are arranged in the rack.

12. The computer system (10) according to claim 11, wherein the rack includes a plurality of front slots for the horizontal blades (14) and the vertical blades (12) and a plurality of rear slots for the connecting blades (20).

13. The computer system (10) according to claim 12, wherein each horizontal blade (14), each vertical blade (12) and/or each connecting blade (20) is insertable into the respective slot of the rack, in particular for establishing the respective connections between the horizontal blades (14), the vertical blades (12) and the connecting blades (20).

## Patentansprüche

1. Computersystem (10), wobei das Computersystem (10) aufweist:
- eine Mehrzahl von vertikalen Einschubmodulen (12);
- eine Mehrzahl von horizontalen Einschubmodulen (14), wobei die horizontalen Einschubmodule (14) obere horizontale Einschubmodule (16) und untere horizontale Einschubmodule (18) aufweisen, wobei die oberen horizontalen Einschubmodule (16) oberhalb der vertikalen Einschubmodule (12) angeordnet sind und die unteren horizontalen Einschubmodule (18) unterhalb der vertikalen Einschubmodule (12) angeordnet sind; und
- eine Mehrzahl von Verbindungseinschubmodulen (20), wobei die Verbindungseinschubmodule (20) obere Verbindungseinschubmodule (22) und untere Verbindungseinschubmodule (24) aufweisen,
wobei jedes obere Verbindungseinschubmodul (22) mit einem der vertikalen Einschubmodule (12) und mit jedem oberen horizontalen Einschubmodul (16) verbunden ist, wobei jedes untere Verbindungseinschubmodul (24) mit einem der vertikalen Einschubmodule (12) und mit jedem unteren horizontalen Einschubmodul (18) verbunden ist,
wobei jedes horizontale Einschubmodul (14) und jedes vertikale Einschubmodul (12) zumindest eine elektronische Komponente aufweist, wobei die elektronischen Komponenten der horizontalen Einschubmodule (14) und die elektronischen Komponenten der vertikalen Einschubmodule (12) über die Verbindungseinschubmodule (20) in einer Leaf-Spine-Topologie verbunden sind, wobei jedes horizontale Einschubmodul (14) zumindest eine Leaf-Komponente aufweist und jedes vertikale Einschubmodul (12) zumindest eine Spine-Komponente aufweist, wobei jede Leaf-Komponente mit jeder Spine-Komponente über die Verbindungseinschubmodule (20) verbunden ist, wobei jedes horizontale Einschubmodul (14) einen oder mehrere Rechenchips (38) aufweist und jedes vertikale Einschubmodul (12) einen oder mehrere Switch-Chips (54) aufweist, wobei jeder Rechenchip (38) eine Leaf-Komponente ist und jeder Switch-Chip (54) eine Spine-Komponente ist.

2. Computersystem (10) nach Anspruch 1, wobei jedes horizontale Einschubmodul (14) eine Mehrzahl von horizontales-Einschubmodul-Verbindern (36) aufweist, wobei jedes vertikale Einschubmodul (12) eine Mehrzahl von vertikales-Einschubmodul-Verbindern (50, 52) aufweist, wobei die vertikales-Einschubmodul-Verbinder (50, 52) obere vertikales-Einschubmodul-Verbinder (50) und untere vertikales-Einschubmodul-Verbinder (52) aufweisen, wobei jedes obere Verbindungseinschubmodul (22) konfiguriert ist, um Kommunikationsverbindungen von einem horizontales-Einschubmodul-Verbinder (36) jedes oberen horizontalen Einschubmoduls (16) zu den oberen vertikales-Einschubmodul-Verbindern (50) des entsprechenden vertikalen Einschubmoduls (12) herzustellen, wobei jedes untere Verbindungseinschubmodul (24) konfiguriert ist, um Kommunikationsverbindungen von einem horizontales-Einschubmodul-Verbinder (36) jedes unteren horizontalen Einschubmoduls (18) zu dem unteren vertikales-Einschubmodul-Verbinder (52) des entsprechenden vertikalen Einschubmoduls (12) herzustellen, insbesondere wobei die hergestellten Kommunikationsverbindungen optische und/oder elektrische Verbindungen sind.

3. Computersystem (10) nach Anspruch 2, wobei jedes Verbindungseinschubmodul (20) eine Mehrzahl von Verbindungseinschubmodul-Verbindern (60, 62) aufweist, wobei die Verbindungseinschubmodul-Verbinder (60, 62) erste Verbindungseinschubmodul-Verbinder (60) und einen oder mehrere zweite Verbindungseinschubmodul-Verbinder (62) aufweisen, wobei sich jeder erste Verbindungseinschubmodul-Verbinder (60) mit einem jeweiligen horizontales-Einschubmodul-Verbinder (36) verbindet, wobei sich jeder zweite Verbindungseinschubmodul-Verbinder (62) mit einem jeweiligen vertikales-Einschubmodul-Verbinder (50, 52) verbindet.

4. Computersystem (10) nach Anspruch 2 oder 3, wobei jedes horizontale Einschubmodul (14), jedes vertikale Einschubmodul (12) und/oder jedes Verbindungseinschubmodul (20) ein Gehäuse (34, 48, 58) aufweist, wobei die jeweiligen Verbinder (36, 50, 52, 60, 62) in Bezug auf das Gehäuse (34, 48, 58) in einer festen Position montiert sind.

5. Computersystem (10) nach einem der Ansprüche 2 bis 4, wobei jedes Verbindungseinschubmodul (20) eine PCB-Leiterplatte (68) aufweist, um jeweilige Kommunikationsverbindungen zwischen den jeweiligen horizontalen Einschubmodulen (14) und dem entsprechenden vertikalen Einschubmodul (12) zu implementieren, wobei insbesondere eine Leiterplattenebene jeder PCB-Leiterplatte (68) parallel oder orthogonal zu einer Verbindungsebene zwischen den Verbindungseinschubmodulen (20) und den horizontalen und vertikalen Einschubmodulen (12, 14) ist.

6. Computersystem (10) nach einem der Ansprüche 2 bis 4, wobei jedes Verbindungseinschubmodul (20) ein oder mehrere Kabel (64) aufweist, um die jeweiligen Kommunikationsverbindungen zwischen den jeweiligen horizontalen Einschubmodulen (14) und dem entsprechenden vertikalen Einschubmodul (12) zu implementieren.

7. Computersystem (10) nach Anspruch 6, wobei die horizontales-Einschubmodul-Verbinder (36) und die vertikales-Einschubmodul-Verbinder (50, 52) optische Signalübertragung verwenden, wobei die eine oder mehreren Kabel (64) jedes Verbindungseinschubmoduls (20) Lichtwellenleiter aufweisen, insbesondere von jedem horizontales-Einschubmodul-Verbinder (36) zu seinem entsprechenden vertikales-Einschubmodul-Verbinder (50, 52).

8. Computersystem (10) nach Anspruch 6 oder 7, wobei jedes Verbindungseinschubmodul (20) ein oder mehrere mehrköpfige Kabel aufweist, wobei jedes mehrköpfige Kabel aus zwei oder mehr der Kabel (64) gebildet ist, wobei jedes mehrköpfige Kabel einen jeweiligen vertikales-Einschubmodul-Verbinder (50, 52) des entsprechenden vertikalen Einschubmoduls (12) mit einem horizontales-Einschubmodul-Verbinder (36) von zwei oder mehr der jeweiligen horizontalen Einschubmodule (14) verbindet.

9. Computersystem (10) nach einem der Ansprüche 1 bis 8, wobei jedes horizontale Einschubmodul (14) einen Speicher (40) und/oder eine oder mehrere Erweiterungsvorrichtungen (42) aufweist, insbesondere wobei in jedem horizontalen Einschubmodul (14) der Speicher (40) und/oder die eine oder mehreren Erweiterungsvorrichtungen (42) mit dem Rechenchip (38) verbunden sind.

10. Computersystem (10) nach einem der Ansprüche 1 bis 9, wobei die Anzahl der oberen horizontalen Einschubmodule (16) gleich groß ist wie die Anzahl der unteren horizontalen Einschubmodule (18) oder unterschiedlich von der Anzahl der unteren horizontalen Einschubmodule (18) ist.

11. Computersystem (10) nach einem der Ansprüche 1 bis 10, wobei das Computersystem (10) ein Rack aufweist, wobei die horizontalen Einschubmodule (14), die vertikalen Einschubmodule (12) und die Verbindungseinschubmodule (20) in dem Rack angeordnet sind.

12. Computersystem (10) nach Anspruch 11, wobei das Rack eine Mehrzahl von vorderseitigen Steckplätzen für die horizontalen Einschubmodule (14) und die vertikalen Einschubmodule (12) und eine Mehrzahl von rückseitigen Steckplätzen für die Verbindungseinschubmodule (20) umfasst.

13. Computersystem (10) nach Anspruch 12, wobei jedes horizontale Einschubmodul (14), jedes vertikale Einschubmodul (12) und/oder jedes Verbindungseinschubmodul (20) in den jeweiligen Steckplatz des Racks einsetzbar ist, insbesondere zum Herstellen der jeweiligen Verbindungen zwischen den horizontalen Einschubmodulen (14), den vertikalen Einschubmodulen (12) und den Verbindungseinschubmodulen (20).

## Revendications

1. Système informatique (10), dans lequel le système informatique (10) comprend :
- une pluralité de lames verticales (12) ;
- une pluralité de lames horizontales (14), les lames horizontales (14) comprenant des lames horizontales supérieures (16) et des lames horizontales inférieures (18), les lames horizontales supérieures (16) étant agencées au-dessus des lames verticales (12), les lames horizontales inférieures (18) étant agencées en dessous des lames verticales (12) ; et
- une pluralité de lames de connexion (20), les lames de connexion (20) comprenant des lames de connexion supérieures (22) et des lames de connexion inférieures (24),
dans lequel chaque lame de connexion supérieure (22) est connectée à l'une des lames verticales (12) et à chaque lame horizontale supérieure (16), dans lequel chaque lame de connexion inférieure (24) est connectée à l'une des lames verticales (12) et à chaque lame horizontale inférieure (18),
dans lequel chaque lame horizontale (14) et chaque lame verticale (12) comprend au moins un composant électronique, dans lequel les composants électroniques des lames horizontales (14) et les composants électroniques des lames verticales (12) sont connectés selon une topologie feuille-épine par l'intermédiaire des lames de connexion (20), dans lequel chaque lame horizontale (14) comprend au moins un composant feuille et chaque lame verticale (12) comprend au moins un composant épine, dans lequel chaque composant feuille est connecté à chaque composant épine par l'intermédiaire des lames de connexion (20), dans lequel chaque lame horizontale (14) comprend une ou plusieurs puces informatiques (38) et chaque lame verticale (12) comprend une ou plusieurs puces de commutation (54), dans lequel chaque puce informatique (38) est un composant feuille et chaque puce de commutation (54) est un composant épine.

2. Système informatique (10) selon la revendication 1, dans lequel chaque lame horizontale (14) comprend une pluralité de connecteurs de lame horizontale (36), dans lequel chaque lame verticale (12) comprend une pluralité de connecteurs de lame verticale (50, 52), dans lequel les connecteurs de lame verticale (50, 52) comprennent des connecteurs de lame verticale supérieurs (50) et des connecteurs de lame verticale inférieurs (52), dans lequel chaque lame de connexion supérieure (22) est configurée pour établir des connexions de communication d'un connecteur de lame horizontale (36) de chaque lame horizontale supérieure (16) aux connecteurs de lame verticale supérieurs (50) de la lame verticale correspondante (12), dans lequel chaque lame de connexion inférieure (24) est configurée pour établir des connexions de communication d'un connecteur de lame horizontale (36) de chaque lame horizontale inférieure (18) au connecteur de lame verticale inférieur (52) de la lame verticale correspondante (12), en particulier dans lequel les connexions de communication établies sont des connexions optiques et/ou électriques.

3. Système informatique (10) selon la revendication 2, dans lequel chaque lame de connexion (20) comprend une pluralité de connecteurs de lame de connexion (60, 62), dans lequel les connecteurs de lame de connexion (60, 62) comprennent des premiers connecteurs de lame de connexion (60) et un ou plusieurs seconds connecteurs de lame de connexion (62), dans lequel chaque premier connecteur de lame de connexion (60) se connecte à un connecteur de lame horizontale respectif (36), dans lequel chaque second connecteur de lame de connexion (62) se connecte à un connecteur de lame verticale respectif (50, 52).

4. Système informatique (10) selon la revendication 2 ou 3, dans lequel chaque lame horizontale (14), chaque lame verticale (12) et/ou chaque lame de connexion (20) comprend un boîtier (34, 48, 58), dans lequel les connecteurs respectifs (36, 50, 52, 60, 62) sont montés dans une position fixe par rapport au boîtier (34, 48, 58).

5. Système informatique (10) selon l'une quelconque des revendications 2 à 4, dans lequel chaque lame de connexion (20) comprend une carte de circuit imprimé (68) pour mettre en œuvre des connexions de communication respectives entre les lames horizontales respectives (14) et la lame verticale correspondante (12), en particulier dans lequel un plan de carte de chaque carte de circuit imprimé (68) est parallèle ou orthogonal à un plan de connexion entre les lames de connexion (20) et les lames horizontales et verticales (12, 14).

6. Système informatique (10) selon l'une quelconque des revendications 2 à 4, dans lequel chaque lame de connexion (20) comprend un ou plusieurs câbles (64) pour mettre en œuvre les connexions de communication respectives entre les lames horizontales respectives (14) et la lame verticale correspondante (12).

7. Système informatique (10) selon la revendication 6, dans lequel les connecteurs de lame horizontale (36) et les connecteurs de lame verticale (50, 52) utilisent une signalisation optique, dans lequel le ou les plusieurs câbles (64) de chaque lame de connexion (20) comprennent des fibres optiques, en particulier de chaque connecteur de lame horizontale (36) à son connecteur de lame verticale correspondant (50, 52).

8. Système informatique (10) selon la revendication 6 ou 7, dans lequel chaque lame de connexion (20) comprend un ou plusieurs câbles à têtes multiples, dans lequel chaque câble à têtes multiples est formé de deux câbles (64) ou plus, dans lequel chaque câble à têtes multiples connecte un connecteur de lame verticale respectif (50, 52) de la lame verticale correspondante (12) à un connecteur de lame horizontale (36) de deux lames horizontales respectives (14) ou plus.

9. Système informatique (10) selon l'une quelconque des revendications 1 à 8, dans lequel chaque lame horizontale (14) comprend une mémoire (40) et/ou un ou plusieurs dispositifs d'extension (42), en particulier dans lequel, dans chaque lame horizontale (14), la mémoire (40) et/ou le ou les plusieurs dispositifs d'extension (42) sont connectés à la puce informatique (38).

10. Système informatique (10) selon l'une quelconque des revendications 1 à 9, dans lequel le nombre des lames horizontales supérieures (16) est identique ou différent du nombre des lames horizontales inférieures (18).

11. Système informatique (10) selon l'une quelconque des revendications 1 à 10, dans lequel le système informatique (10) comprend une baie, dans lequel les lames horizontales (14), les lames verticales (12) et les lames de connexion (20) sont agencées dans la baie.

12. Système informatique (10) selon la revendication 11, dans lequel la baie comprend une pluralité de fentes avant pour les lames horizontales (14) et les lames verticales (12) et une pluralité de fentes arrière pour les lames de connexion (20).

13. Système informatique (10) selon la revendication 12, dans lequel chaque lame horizontale (14), chaque lame verticale (12) et/ou chaque lame de connexion (20) peut être insérée dans la fente respective de la baie, en particulier pour établir les connexions respectives entre les lames horizontales (14), les lames verticales (12) et les lames de connexion (20).
